# EUROPEAN PATENT SPECIFICATION

(11) **EP 3 088 561 B1**
(45) Date of publication and mention of the grant of the patent: **01.05.2019**
(21) Application number: 16163235.1
(22) Date of filing: 31.03.2016
(51) Int. Cl.: C23C 14/50, C23C 14/54, C23C 14/58

(54) **HYBRID VACUUM FURNACE**
HYBRIDER VAKUUMOFEN
FOUR À VIDE HYBRIDE

(30) Priority: 29.04.2015 PL 41215715
(43) Date of publication of application: 02.11.2016
(73) Proprietor: AMP Sp. z o.o., 65-022 Zielona Góra (PL)
(72) Inventor: FLISIEWICZ, Bogdan, 66-200 Swiebodzin (PL); CYGANSKI, Maciej, 66-200 Swiebodzin (PL); GULBINSKI, Witold, 75-376 Koszalin (PL); WALKOWICZ, Jan, 75-343 Koszalin (PL)
(74) Representative: Malcherek, Piotr

(56) References cited:
- DE-A1- 4 443 740
- JP-A- 2004 156 144

## Description

The invention relates to a hybrid vacuum furnace applied in particular for thermochemical treatment of metals and deposition of materials onto treated workpieces performed in vacuum from gas phase (PVD).

For example, US 5,363,400 discloses a furnace for deposition of metal coatings onto metal parts, possibly deposition of alloys in vacuum from gas phase from cathodes of PVD sources, wherein said furnace has a sealed housing inside which there is a working chamber made of thermally insulative material, said chamber delimiting the working space of the furnace, accommodating the treated workpieces which may be placed on a fixed working table, electrically insulated from the vacuum-sealed housing, said table being made of an electrically conductive material, connected to a bias voltage source. The interior of the chamber is connected to a system of vacuum pumps and to a system for reactive or possibly neutral gas distribution, whose circulation inside the furnace is fan-induced. The heating of the workpieces is carried out by means of resistance heating elements located inside the working chamber, wherein inside said working chamber there is at least one metal vapour generator located in the vicinity of the treated workpieces.

The vapour generator has a load-bearing structure in the form of a tubular connection member with a cathode being fixed thereto, and said cathode is made of material to be evaporated and subsequently deposited on the treated workpieces, with an electrically insulated flange, said connection member passing through an opening in the sealed housing of the furnace, and said vapour generator being equipped with a yoke made of insulative material surrounding the tubular connection member, and a conductive rod connected to the cathode, said rod going through said yoke, an electromagnetic coil located near the cathode arranged around the rod and a cooling system comprising an inlet pipe of the cooling fluid with a transverse passage crossing the yoke. The cooling system of the cathode is connected with an axial channel via an opening in the plate near the cathode, provided for connecting the axial channel with an intermediate space located between the connection member and the rod. An outlet pipe of the cooling system passing through the yoke is connected to the intermediate space. The described vapour generator may comprise a movable electrode exciting an arc discharge on the front surface of the cathode. The vapour generator may also comprise an electrostatic screen, coaxial with the tubular connection member, located between said yoke and a bushing, slidably mounted around the cathode and arranged on the floating potential.

The so constructed furnace allows to carry out PVD process as well as thermal and thermochemical treatment with a pressure ranging from 0.8 to 10 Pa and temperature ranging between 400 and 1300 degrees Celsius, with the use of neutral or reactive gases, for a wide range of applications. The workpieces to be treated remain immovable with respect to the arc sources and may be negatively polarized with impulse voltage of several hundred Volts with respect to the sealed housing. The furnace is suitable for performing various processes which may be carried out subsequently. One of the main disadvantages of such a furnace is too high final pressure of the treatment process, which makes the processes of deposition from gas phase with PVD cathodes of an adequate pretreatment impossible. At the same time the vapour arc generators are mounted in such a manner that the cooled cathodes thereof are mounted in the openings provided in the thermal insulation of the high-temperature chamber, which significantly hinders an even distribution of temperature in said chamber during high-temperature treatment and the cooled cathodes of said generators are prone to condensation of impurities during such processes. Furthermore, the vapour arc generators are exposed to high temperatures during the thermal and thermochemical treatment processes, whereas the lack of cathode diaphragms of said generators inhibits cleaning thereof by means of the arc discharge prior to beginning the PVD process. Another disadvantage of this solution is the immovable table, which hinders the possibility of achieving a coating of a homogenous thickness or a uniform chemical composition, in particular in case of deposition of multi-material and multi-layer coatings from several sources, when the number of workpieces is significant.

JP2004156144 discloses a small magnetron sputtering device which enables easy maintenance and forms a film with a high adhesion strength. In this magnetron sputtering device for forming the film on the surface of a substrate by evaporating a target material through sputtering, around the substrate or a support for placing the substrate, the target and a substrate-heating heater are provided in a circumferential direction around a central axis of the substrate or the support without interfering with each other. Furthermore a shutter is provided to block between the target and the substrate at heating or target activation and between the substrate-heating heater and the substrate at ion bombardment or evaporation. The shutter also serves as an anode.

DE4443740 discloses a plasma deposition apparatus, for example for hard coating of tools. This apparatus has a vacuum chamber which has cooled outer walls and which contains at least one rotating and especially exchangeable substrate holder and at least one evaporative source facing the substrate holder. A closed inner chamber is provided within the vacuum chamber and spaced from the cooled outer walls to form an isolated plasma-free interspace, the inner chamber being defined by heating and wall sectors and at least one integrated evaporative source and forming an isothermal coating space which receives the substrate holder.

The aim of the present invention is to provide a hybrid vacuum furnace of such construction that carrying out various processes of metal parts finishing will be possible without the necessity to change tools or to unload or transfer the batch and the duration of the engineering processes can be minimised.

The essence of the present invention is that the furnace comprises PVD cathodes arranged in mutually symmetrically arranged pockets of the vacuum-pressure housing, and a heating chamber located therebetween made of a thermally insulated material has open sides arranged opposite said PVD cathodes, and inside said heating chamber there is a rotatable table with individual seats and/or holders on rotatable supports with axes of rotation parallel to the axes of rotation of the rotatable table. Between the pockets of the PVD cathodes and the open sides of the heating chamber there are movable diaphragms.

Accordingly the invention provides a hybrid vacuum furnace as defined in the claims.

The most advantageous position of the PVD cathodes with respect to the treated workpieces is achieved when said cathodes are slidably arranged in the pockets along the pocket's longitudinal axis so that the distance between said cathodes and the treated workpieces may be decreased or increased.

Preferably, the movable diaphragms are of a shutter construction, which makes covering and uncovering of the PVD cathodes simple.

It is most preferable that the diaphragms be arranged in the pressure-vacuum housing slidably along the longitudinal axis thereof on the sections between the PVD cathodes and the heating chamber, and on the external outline of said diaphragms there be a cooler ensuring smooth adjustment of the cooling process of the heating chamber interior.

It is preferable that the furnace used for plasma nitriding be so constructed that the interior of the heating chamber is surrounded by a mesh screen connected to a high voltage source, insulated from the heating chamber and/or the pressure-vacuum housing, and in the upper part of the heating chamber there is a fan and an outlet gap, which ensures a uniform flow of process gases through the heating chamber.

In order to facilitate handling of the treated workpieces, the table supporting them including the seats and/or holders is arranged in the heating chamber in a pull-out manner.

In another preferred embodiment, the rotatable supports of the seats and/or holders are fixed to the table around an outline of a circle whose centre is the axis of rotation of the table, and seats and/or holders with latches for securing the treated workpieces are arranged on the rotatable supports, which ensures uniform conditions for the finishing process carried out inside the heating chamber.

In this case a planetary gear is most advantageous for driving the rotatable supports, and said planetary gear also drives the rotation of the table.

It is particularly advantageous to apply a planetary gear of parameters so selected that each rotatable support performs at least one full revolution around its axis of rotation at the width of opening of the pockets with the PVD cathodes placed therein during one revolution of the table around its axis of rotation.

The main advantage of the furnace according to the invention is that it is possible to subsequently perform engineering process therein without the necessity to remove the batch from the furnace or to use different furnaces to carry out finishing processes on the same workpieces. In high-temperature processes, the diaphragms of the PVD cathodes prevent overheating of said PVD cathodes as well as condensation of impurities and enable cleaning the surface thereof prior to performing the PVD process. This is possible due to the properly selected depth of the pockets, which allows to activate the generator with a closed diaphragm. The diaphragms are controlled by means of hydraulic actuators operated with a properly programmed controller. Due to the fact that the table in the heating chamber is rotatably mounted, the mounted thereto supports for securing the treated workpieces in their seats and/or holders are also rotatably mounted to said table, all the treated workpieces are exposed to the same conditions during a given process. The rotatably mounted table is electrically insulated by means of insulators from the pressure-vacuum housing and does not have contact with the heating chamber, which allows for an independent electric polarization of the supports and load-bearing elements. Polarization voltage is also automatically connected by means of an actuator operated with a controller.

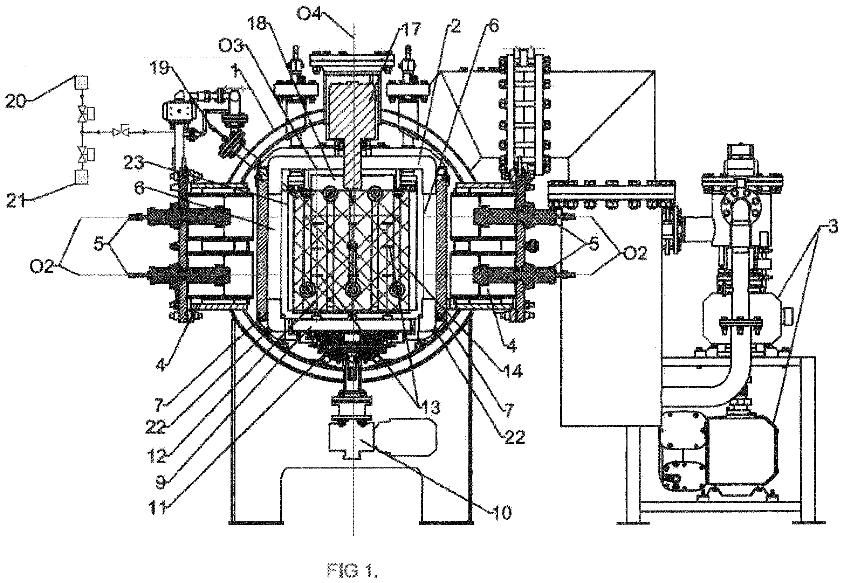

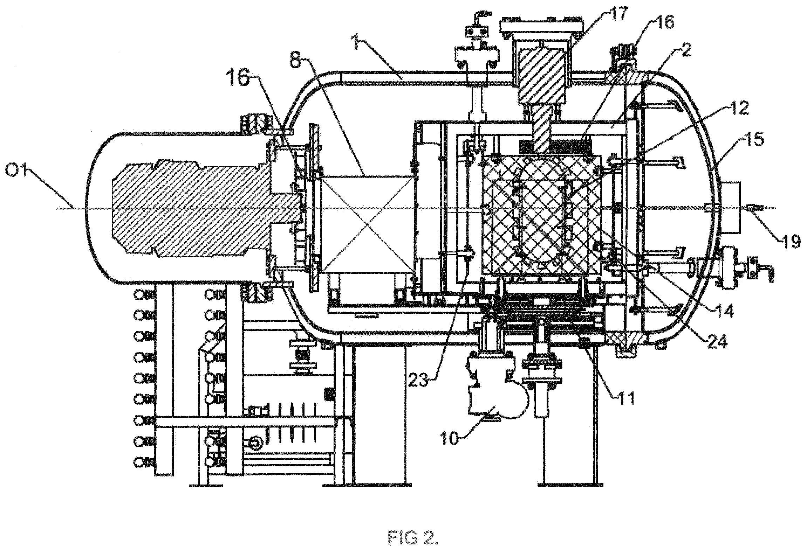

The invention is presented in more detail in an embodiment shown in the drawing, where fig. 1 is a simplified cross-section of the hybrid vacuum furnace, and fig. 2 is a simplified longitudinal section of the furnace.

A hybrid vacuum furnace comprising a cylinder shaped pressure-vacuum housing 1 (fig. 1, fig. 2) with a horizontal longitudinal axis O1 has a cuboid shaped, thermally insulated heating chamber 2. The pressure-vacuum housing 1 is connected to a system of pumps 3 provided for achieving dynamic vacuum, higher than 10⁻² Pa for a batch of ambient temperature. The pressure-vacuum housing 1 has situated opposite each other symmetrical pockets 4 in which pairs of PVD cathodes 5 are arranged, wherein the heating chamber 2 located between said pockets 4 and from the side of the PVD cathodes 5 has open sides. The PVD cathodes 5 are slidably mounted in the pockets 4 along the axis 02 thereof, wherein between said PVD cathodes 5 and the heating chamber 2 there are diaphragms 7 of a shutter construction. The diaphragms 7 may be slid along the longitudinal axis O1. Near the external outline of the diaphragm 7 there is a cooler 8 (fig. 2). Inside the heating chamber 2 there is a rotatable table 9 actuated from a drive 10 via a planetary gear 11, wherein said rotatable table 9 comprises rotatable supports 12 arranged on the outline of said rotatable table 9, and said supports 12 having individual seats and/or holders 13 for securing the treated workpieces. The rotatable supports 12 are also driven by the planetary gear 11, and their axes of rotation 03 are parallel to the axis of rotation 04 of the table 9. Preferably, the planetary gear 11 has such ratios that each rotatable support 12 performs at least one full revolution around its axis of rotation 03 at the opening width of the pocket 4 with the PVD cathodes 5 placed therein during the revolution of the table 9 around its axis of rotation 04. The interior of the heating chamber 2 may comprise a mesh screen 14 fixed thereto, connected to high voltage and electrically insulated from the table 9 and the pressure-vacuum housing 1, said mesh screen 14 made of heat-resistant steel surrounds the rotatable table 9 with a movable front wall from the side of a door 15 of the heating chamber 2 provided for pulling out the batch without dismounting said mesh screen 14. The side walls of the mesh screen 14 are active surfaces and perform the function of a glow discharge cathode. In the upper part of the heating chamber 2 there is a fan 16 driven by a drive unit 17, and in the top of the heating chamber 2 there is a gap 18 being an outlet opening for process gases, located within the axis of the working space of the batch. The batch temperature is measured with thermocouples 19, and valves 20, 21 are used for feeding process gases, for example nitrogen and hydrogen into the heating chamber 2, wherein said gases are fed through gas manifolds 22. Heating elements 23, 24 are provided for heating the batch. The furnace is also equipped with pressure measuring elements.

## Claims

1. A hybrid vacuum furnace having a sealed pressure-vacuum housing /1/ with inlet and outlet manifolds /22/ for process gases, heating elements /23, 24/ and PVD cathodes /5/ arranged mutually opposite, and a located therebetween heating chamber /2/ with a table /9/ being a support of holders and/or seats /13/ for securing the treated workpieces, cooperating with a vacuum pump, **characterised in that** the PVD cathodes /5/ are placed in mutually symmetrically arranged pockets /4/ of the pressure-vacuum housing /1/, and the located therebetween heating chamber /2/ made of thermally insulated material has open sides /6/ situated opposite the PVD cathodes /5/ and inside said heating chamber /2/ is the rotatable table /9/ equipped with individual seats and/or holders /13/ on rotatable supports /12/ with axes of rotation /O3/ parallel to the axes of rotation /O4/ of the table /9/, wherein between the pockets /4/ of the PVD cathodes /5/ and the open sides /6/ of the heating chamber /2/ there are movable diaphragms /7/.

2. The furnace according to claim 1, **characterised in that** the PVD cathodes /5/ are placed in the pockets /4/ slidably along the longitudinal axes /O2/ thereof.

3. The furnace according to claim 1 or 2, **characterised in that** the diaphragms /7/ are of a shutter construction.

4. The furnace according to claim 3, **characterised in that** the diaphragms /7/ are arranged in the pressure-vacuum housing /1/ slidably along the longitudinal axis /O1/ between the PVD cathodes /5/ and the heating chamber /2/ and at the external outline thereof there is a cooler /8/.

5. The furnace according to claim 1, **characterised in that** the interior of the heating chamber /2/ is surrounded by a mesh screen /14/ connected to a high voltage source, electrically insulated from the heating chamber /2/ and/or the pressure-vacuum housing /1/, and in the upper part of the heating chamber /2/ there is a fan /16/ and an outlet gap /18/ for process gases.

6. The furnace according to claim 1 or 5, **characterised in that** the table /9/ with the rotatable supports /12/ and seats and/or holders /13/ is mounted in the heating chamber /2/ in a pull-out manner.

7. The furnace according to claim 1, **characterised in that** the rotatable supports /12/ of the seats and/or holders /13/ are fixed to the table /9/ around an outline of a circle, and the centre of said circle is constituted by the axis of rotation /O4/ of the table /9/ and on said rotatable supports /12/ are arranged seats and/or holders /13/ with latches for securing the treated workpieces.

8. The furnace according to claim 1 or 7, **characterised in that** the drive of the rotatable supports /12/ is carried out by means of a planetary gear /11/ also driving the table /9/.

9. The furnace according to claim 8, **characterised in that** the planetary gear /11/ has such rations that each rotatable support /12/ performs at least one full revolution around its axis of rotation /O3/ at the width of opening of the pocket /4/ containing the PVD cathodes /5/ during one revolution of the table /9/ around its axis of rotation /O4/.

## Patentansprüche

1. Hybrid-Vakuumofen mit abgedichtetem Vakuum-Druckgehäuse (1), ausgestattet mit Zu- und Abflusskollektoren (22) von Prozessgasen, Heizelementen (23, 24) und PVD-Kathoden (5), die einander gegenüberliegend angeordnet sind, zwischen denen sich eine Heizkammer (2) mit einem Tisch (9) befindet, der einen Träger von Halterungen und / oder Buchsen (13) zum Fixieren der zu bearbeitenden Elementen bildet und mit einer Vakuumpumpe zusammenwirkt, **dadurch gekennzeichnet, dass** die PVD-Kathoden (5) in symmetrisch zueinander angeordneten Taschen (4) im Vakuum-Druckgehäuse (1) platziert sind, und die zwischen ihnen lokalisierte Heizkammer (2) aus Wärmeisolationsmaterial offene, gegenüber PVD-Kathoden (5) liegende Seiten (6) aufweist, und im deren Inneren befindet sich ein Drehtisch (9), ausgestattet mit individuellen Buchsen und / oder Halterungen (13) auf Drehstützen (12), deren Drehachsen (03) parallel zur Drehachse (04) des Tisches (9) verlaufen, wobei bewegliche Bildschirme (7) zwischen den Taschen (4) der PVD-Kathoden (5) und den offenen Seiten (6) der Heizkammer (2) liegen.

2. Ofen nach Anspruch 1, **dadurch gekennzeichnet, dass** die PVD-Kathoden (5) in den Taschen (4) entlang ihrer Längsachsen (02) gleitend angeordnet sind.

3. Ofen nach Anspruch 1 oder 2, **dadurch gekennzeichnet, dass** die Bildschirme (7) eine Jalousiekonstruktion aufweisen.

4. Ofen nach Anspruch 3, **dadurch gekennzeichnet, dass** die Bildschirme (7) im Vakuum-Druckgehäuse (1) entlang der Längsachse (O1) zwischen den PVD-Kathoden (5) und der Heizkammer (2) gleitend gelagert sind und an ihrer Außenkontur ein Kühler (8) angeordnet ist.

5. Ofen nach Anspruch 1, **dadurch gekennzeichnet, dass** der Innenraum der Heizkammer (2) von einem Gitterschirm (14) umgeben ist, der mit einer Hochspannungsquelle verbunden ist, die von der Heizkammer (2) und / oder dem Vakuum-Druckgehäuse (1) elektrisch isoliert ist, und im oberen Teil der Heizkammer (2) sich ein Lüfter (16) und ein Austrittsspalt (18) der technologischen Gase befinden.

6. Ofen nach Anspruch 1 oder 5, **dadurch gekennzeichnet, dass** der Tisch (9) zusammen mit den Drehstützen (12) und Buchsen und / oder Halterungen (13) in der Heizkammer (2) ausfahrbar einbettet ist.

7. Ofen nach Anspruch 1, **dadurch gekennzeichnet, dass** die Drehstützen (12) der Buchsen und / oder Halterungen (13) am Tisch (9) entlang einer Kreiskontur befestigt sind, deren Mittelpunkt die Drehachse (04) des Tisches (9) darstellt und an den Drehstützen (12) Buchsen und / oder Halterungen (13) mit Haken zur Befestigung der zu bearbeitenden Elementen angeordnet sind.

8. Ofen nach Anspruch 1 oder 7, **dadurch gekennzeichnet, dass** der Antrieb der Drehstützen (12) durch ein Planetengetriebe (11) realisiert wird, das ebenfalls den Tisch (9) antreibt.

9. Ofen nach Anspruch 8, **dadurch gekennzeichnet, dass** das Planetengetriebe (11) solche Getriebeübersetzungen aufweist, dass jeder Drehstützen (12) mindestens eine volle Rotation um seine Drehachse (03) auf Öffnungsweite der Taschen (4) mit den PVD-Kathoden (5) während der Drehung des Tisches (9) um seine Drehachse (04) führt.

## Revendications

1. Un four hybride sous vide, comportant une enceinte étanchéisée sous vide de pression /1/ équipée de collecteurs /22/ d'entrée et de sortie des gaz de traitement, d'éléments chauffants /23,24/ et de cathodes PVD /5/ placés en vis-à-vis, entre lesquels se trouve une chambre de chauffage /2/ avec une table /9/ portant des supports et / ou des alvéoles /13/ pour la fixation des pièces à traiter, fonctionnant à l'aide d'une pompe à vide, **caractérisée en ce que** les cathodes PVD /5/ sont placées dans des poches /4/ situées symétriquement les unes par rapport aux autres dans l'enceinte sous vide de pression /1/, et que la chambre thermique /2/ en matériau isolant thermique située entre elles a des côtés ouverts /6/ placés en face des cathodes PVD /5/ tandis qu'à l'intérieur de la chambre se trouve une table rotative /9/ équipée d'alvéoles /13/ et/ou de poignées sur des supports rotatifs /12/ dont les axes de rotation /03/ sont parallèles à l'axe de rotation /04/ de la table /9/, tandis que les obturateurs mobiles /7/ sont disposés entre les poches /4/ de la cathode PVD/5/ et les côtés ouverts /6/ de la chambre de chauffage /2/.

2. Un four selon la revendication 1, **caractérisé en ce que** les cathodes PVD /5/ sont disposées dans les poches /4/ coulissantes le long de leur axe longitudinal /02/.

3. Un four selon la revendication 1 ou 2, **caractérisé en ce que** les obturateurs (7) ont une structure de registre à lamelles.

4. Un four selon la revendication 3, **caractérisé en ce que** les obturateurs /7/ sont montés dans l'enceinte sous vide de pression /1/ de manière coulissante le long de l'axe longitudinal /O1/ entre les cathodes PVD /5/ et la chambre de chauffage /2/, et sur leur contour extérieur est placé un refroidisseur /8/.

5. Un four selon la revendication 1, **caractérisé en ce que** l'espace intérieur de la chambre de chauffage /2/ est entouré d'un écran maillé /14/ connecté à une source de haute tension, isolée électriquement de la chambre de chauffage /2/ et/ou de l'enceinte sous vide /1/, et **en ce que** dans la partie supérieure de la chambre de chauffage /2/, se trouve un ventilateur /16/ et une ouverture de sortie des gaz de traitement /18/.

6. Un four selon la revendication 1 ou 5, **caractérisé en ce que** la table /9/ avec les supports tournants /12/ ainsi qu'avec les alvéoles et/ou les supports /13/ est fixée dans la chambre de chauffage /2/ de façon rétractable.

7. Un four selon la revendication 1, **caractérisé en ce que** les supports pivotants /12/ des alvéoles et / ou des supports /13/ sont fixés à la table /9/ le long d'un contour circulaire dont le centre est l'axe de rotation /04/ de la table /9/ et sur les supports pivotants /12/ sont réparties les alvéoles et/ou les supports /13/ avec des crochets pour fixer des pièces à traiter.

8. Un four selon la revendication 1 ou 7, **caractérisé en ce que** l'entraînement des supports tournants /12/ est réalisé par un réducteur planétaire /11/, entraînant également la table /9/.

9. Un four selon la revendication 8, **caractérisé en ce que** le réducteur planétaire /11/ présente des rapports tels que chaque support pivotant /12/ effectue au moins une rotation complète autour de son axe de rotation /03/ sur la largeur de l'ouverture de la poche /4/ avec les cathodes PVD /5/ lors de la rotation de la table/9/ autour de son axe de rotation /04/.
